# EUROPÄISCHE PATENTSCHRIFT

(11) **EP 3 234 696 B1**
(45) Veröffentlichungstag und Bekanntmachung des Hinweises auf die Patenterteilung: **05.02.2020**
(21) Anmeldenummer: 15816138.0
(22) Anmeldetag: 16.12.2015
(51) Int. Cl.: G03F 7/20, G03F 7/027, G03F 7/32, G03F 7/36

(54) **VERFAHREN ZUR HERSTELLUNG VON FLEXODRUCKFORMEN DURCH MEHRFACHE BELICHTUNG MIT UV-LEDS**
METHOD FOR PRODUCING FLEXOGRAPHIC PRINTING FORMS BY MULTIPLE EXPOSURE USING UV LEDS
PROCÉDÉ DE FABRICATION DE MOULES DE FLEXOGRAPHIE PAR ÉCLAIRAGE MULTIPLE À L'AIDE DE DEL UV

(30) Priorität: 17.12.2014 EP 14198604
(43) Veröffentlichungstag der Anmeldung: 25.10.2017
(73) Patentinhaber: Flint Group Germany GmbH, 70469 Stuttgart (DE)
(72) Erfinder: FRONCZKIEWICZ, Peter, Lake Wylie, South Carolina SC 29710 (US); WENDLAND, Thorben, 71272 Renningen (DE); BEYER, Matthias, 69469 Weinheim (DE)
(74) Vertreter: Schuck, Alexander
(86) Internationale Anmeldenummer: PCT/EP2015/079930
(87) Internationale Veröffentlichungsnummer: WO 2016/096945

(56) Entgegenhaltungen:
- WO-A2-2008/135865
- DE-A1-102010 031 527
- US-A1- 2010 143 840
- US-A1- 2014 057 207

## Beschreibung

Die Erfindung betrifft ein Verfahren zur Herstellung von Flexodruckformen durch mehrfache Belichtung mit UV-LEDs.

Das am weitesten verbreitete Verfahren zur Herstellung von Flexodruckformen umfasst die bildmäßige Belichtung der fotopolymerisierbaren reliefbildenden Schicht mit aktinischer Strahlung, vor allem langwelliger UV-Strahlung, durch eine fotografisch oder digital erstellte Maske. In einem weiteren Verfahrensschritt wird die belichtete Schicht mit einem geeigneten Lösemittel bzw. Lösemittelgemisch behandelt, wobei die unbelichteten, nicht polymerisierten Bereiche der reliefbildenden Schicht gelöst werden, während die belichteten, polymerisierten Bereiche erhalten bleiben und das Relief der Druckplatte bilden.

Digitale Bebilderung von fotoempfindlichen Flexodruckelementen ist prinzipiell bekannt. Hierbei werden Flexodruckelemente nicht auf klassische Art und Weise durch Auflegen einer fotografischen Maske, gefolgt vom Belichten durch die fotografische Maske hindurch, erzeugt. Die Maske wird vielmehr mittels geeigneter Techniken in-situ direkt auf dem Flexodruckelement erzeugt. Flexodruckelemente können beispielsweise mit opaken, IR-ablativen Schichten (EP-B 654 150, EP-A 1 069 475) versehen werden, die mittels IR-Lasern bildmäßig ablatierbar sind. Weitere bekannte Techniken umfassen mittels Ink-Jet-Technik beschreibbare Schichten (EP-A 1 072 953) oder thermografisch beschreibbare Schichten (EP-A 1 070 989). Nach dem bildmäßigen Beschreiben dieser Schichten mittels der dazu geeigneten Techniken wird die fotopolymerisierbare Schicht durch die gebildete Maske hindurch mittels aktinischem Licht belichtet.

Die bildmäßige Belichtung mit aktinischer Strahlung erfolgt standardmäßig unter Verwendung von UV-Strahlungsquellen, die im Bereich von ca. 315 nm bis 420 nm (langwelliger UV-Bereich bis Violettbereich des sichtbaren Spektrums) eine signifikante Emission besitzen. Am häufigsten werden als Strahlungsquelle UV/A-Röhren verwendet, welche ein Emissionsmaximum bei einer Wellenlänge von ca. 370 nm besitzen und UV-Intensitäten von 10 mW/cm² - 30 mW/cm², gemessen in einem Abstand von 50 mm (typischer Abstand der Strahlungsquelle von der Oberfläche des Flexodruckelements) erzeugen. Solche UV/A-Röhren sind beispielsweise unter der Bezeichnung "R-UVA TL 10R" von Philips erhältlich. Weiterhin werden auch Quecksilberdampflampen für die bildmäßige Belichtung verwendet, wobei dotierte Quecksilbermitteldruckdampflampen bevorzugt werden, da z.B. mittels Eisen- und/oder Galliumdotierung der im UV/A-Bereich emittierte Anteil erhöht werden kann.

In jüngster Zeit werden zur Strahlungshärtung von fotopolymerisierbaren Zusammensetzungen zunehmend auch UV-Licht emittierende LEDs (Light Emitting Diodes) eingesetzt.

Gängige LED-Systeme für die UV-Härtung konzentrieren sich in der Praxis gegenwärtig auf die Wellenlängen 395 nm sowie 365 nm. Weitere mögliche Spektralbereiche sind 350 nm, 375 nm, 385 nm, 405 nm. In wissenschaftlichen Veröffentlichungen werden außerdem noch die Wellenlängen 210 nm, 250 nm, 275 nm und 290 nm erwähnt. LEDs zeichnen sich durch eine schmale Intensitätsverteilung (typischer Weise +/- 10 - 20 nm) aus. Sie haben keine nennenswerte Aufwärmphase und sind von ca. 10 bis 100 % der Maximalintensität regelbar.

Mit UV-Leuchtdioden lassen sich Leistungswerte von einigen Watt/cm² erzielen, und der Wirkungsgrad liegt je nach UV-LED-System zwischen 1 und 20 %. Dabei kann die grobe Faustregel gelten: je kürzer die Wellenlänge, desto geringer der Wirkungsgrad. Je kürzer die Emissionswellenlänge sein soll, desto höher die Herstellkosten. Gegenwärtig sind LED-Systeme für die Flächenhärtung kommerziell bei einer Wellenlänge von 395 nm mit einer UV-Leistung zwischen 1-4 W/cm² und bei einer Wellenlänge von 365 nm im Bereich von 0,5 - 2 W/cm² von verschiedenen Anbietern erhältlich.

WO 2008/135865 beschreibt ein Verfahren umfassend das Positionieren einer Druckplatte mit fotovernetzbarem Material auf einer Bebilderungseinheit, das Bebildern der Platte gemäß Bilddaten, die Anwendung von UV-Strahlung von mehreren UVemittierenden Dioden zur Vernetzung des fotovernetzbaren Materials auf der Platte während der Bebilderung der Druckplatte, wobei die Druckplatte eine fotopolymerisierbare Flexodruckplatte, eine fotopolymerisierbare Buchdruckplatte oder ein fotopolymerisierbarer Sleeve sein kann. Weiterhin wird beschrieben, die Platte von der Bebilderungseinheit zu entfernen und anschließend von der Rückseite oder von der Vorderseite und ggf. auch von der Rückseite mit UV-Strahlung von mehreren UVemittierenden Dioden zu belichten.

Während der Belichtung von Fotopolymerplatten mit UV-Licht durch eine durch Laserablation erzeugte Maske tritt als unerwünschter Effekt die Inhibierung der Polymerisation durch Sauerstoff auf, der aus der Umgebungsatmosphäre in die Fotopolymerschicht eindiffundiert. Der gleiche Effekt tritt auf, wenn eine mittels anderer Techniken digital bebilderbare Schicht eingesetzt wird, da diese Schichten im Allgemeinen nur einige Mikrometer dick und damit so dünn sind, dass der Sauerstoff aus der Umgebungsluft durch sie hindurch diffundieren kann.

Flexodruckklischees werden zum Bedrucken von unterschiedlichen Substraten (Folie, Papier, Karton, Wellpappe) eingesetzt. Üblicherweise werden dabei dünnflüssige Druckfarben auf Alkohol- oder Wasserbasis oder UV-Druckfarben eingesetzt.

Ein typisches Merkmal des Flexodruckes ist das Quetschen der dünnflüssigen Druckfarbe über die Ränder der Reliefelemente hinaus. Dieser Effekt ist unerwünscht, da er zu einer Tonwertzunahme im Druck führt. Diese Tonwertzunahme reduziert den Kontrast der Bildwiedergabe und vermindert dadurch die Qualität des Druckbildes.

In jüngster Zeit gibt es mehrere Entwicklungen, die Druckqualität des Flexodruckes durch sogenannte Flat-Top-Dots (FTD) zu steigern. Während übliche digital verarbeitbare Flexodruckplatten unter dem Einfluss von Luftsauerstoff belichtet werden, versucht man bei den FTD-Verfahren den störenden Einfluss des Sauerstoffs auf die Vernetzungsreaktion auszuschalten, um noch feinere Bildelemente wiedergeben zu können und so Auflösung, Kontrast und Farbdeckung zu steigern.

Eine Möglichkeit, den Luftsauerstoff bei der Belichtung auszuschalten, ist beispielsweise die Belichtung unter Stickstoff, wie in US 2009/0186308 beschrieben. In anderen Verfahren wird eine Folie oder eine andere Sauerstoff sperrende Schicht vor der flächigen UV-Belichtung auflaminiert und so die Nachdiffusion des Sauerstoffs verhindert, wie in US 2013/0017493 beschrieben. Die Sperrschicht kann auch in den Aufbau der Flexodruckplatte integriert werden, wie beispielsweise in US 5,262,275 oder in US 8,492,074 beschrieben. Oder es werden photopolymerisierbare Schichten beschrieben, die Zusätze enthalten, die den Einfluss des Sauerstoffs bei der Vernetzungsreaktion ausschalten, wie in US 8,808,968 beschrieben.

In all den genannten Verfahren können feinere Details auf der Flexodruckform reproduziert werden. Im Gegensatz zur Belichtung unter Luftsauerstoff, bei der abgerundete Rasterpunkte (sogenannte Round-Top-Dots, RTD) entstehen, bilden sich bei den FTD-Verfahren Rasterpunkte mit planer Oberfläche und ausgeprägten Kanten aus. Es können so feinere Rasterpunkte und auch hochauflösende Oberflächenstrukturen, die die Farbübertragung verbessern, auf der Druckform abgebildet werden.

Mit zunehmender Verbreitung der FTD-Verfahren werden aber auch die immanenten Nachteile dieser Technologien beim Druck offenbar. FTD-Klischees zeigen im Druck häufig den Effekt des sogenannten Dot-Bridging. Damit bezeichnet der Fachmann das unregelmäßige Zusammenlaufen der Farbe zwischen einzelnen Rasterpunkten im Mitteltonbereich, das für die Praxis nicht akzeptabel ist. Die Ursache des Dot-Bridging ist bislang ungeklärt. Der Effekt kann durch Veränderung der Viskosität der Druckfarbe verringert, oder in höhere Tonwertbereiche verschoben werden, ganz eliminiert werden kann der störende Effekt jedoch nicht. Ein Zusammenhang mit den scharf begrenzten Rändern der FTD-Druckformen liegt aber nahe, da unter Sauerstoff belichtete RTD-Druckformen diesen Effekt nicht zeigen.

Ein elegantes FTD-Verfahren ist die Belichtung der Flexodruckplatte mittels energiereicher UV-LED-Strahlung. In diesem Verfahren wird der Sauerstoff nicht eliminiert, sondern dessen inhibierender Einfluss durch der Belichtung mit energiereicher Strahlung minimiert.

Beispielsweise ist in der WO 2012/010459 die kombinierte Belichtung einer Flexodruckform mittels energiereicher UV-LED-Strahlung, gefolgt von einer Belichtung mit konventionellen UV-Röhren, beschrieben. Die Belichtung wird in einer flachen Ausführungsform beschrieben. Allerdings wäre es aus ökonomischen Gründen wünschenswert, mit einer Strahlungsquelle auszukommen.

Die US 2011/0104615 beschreibt das Verfahren der UV-LED-Belichtung vorzugsweise auf einem Trommelbelichter, an dem seitlich eine UV-LED-Leiste angebracht ist, die sich parallel zur Trommelachse bewegt, während die Trommel rotiert. Die Rotationsgeschwindigkeit der Trommel und damit die pro Belichtungszyklus eingetragene Energie kann variiert werden. Durch Wahl der Umdrehungsgeschwindigkeit hat der Operator die Möglichkeit zu steuern, ob runde oder flache Rasterpunkte auf der Flexodruckform erzeugt werden. Bei einer Umdrehungsgeschwindigkeit von > 60 Umdrehungen pro Minute (RPM) entstehen runde Rasterpunkte. Unterhalb von 60 RPM entstehen flache Rasterpunkte. Begründet wird dieser Effekt mit der während der Belichtung stattfindende Sauerstoffdiffusion. Bei niedriger Belichtungsenergie reicht der in der fotopolymerisierbaren Schicht vorhandene oder nachdiffundierende Sauerstoff aus, um die Vernetzungsreaktion abzubrechen. Es entstehen RTDs. Bei höheren Energiedosen ist die Kettenstartreaktion durch Radikalbildung sehr viel schneller als die Kettenabbruchsreaktion, so dass sich der Einfluss des Sauerstoffs praktisch nicht mehr bemerkbar macht. Es entstehen FTDs.

Auch eine flache Ausführungsform der UV-LED-Belichtung wird beschrieben, wobei die UV-LED-Belichtungseinheit über der Breite der Druckplatte hin- und her geführt wird, während die Druckplatte in Längsrichtung verschoben wird. Die US 2011/0104615 sagt indes nichts darüber aus, wie der Belichtungsprozess gesteuert werden muss, um FTD-Klischees mit optimalen Druckeigenschaften herzustellen.

In der US 8,772,740 wird beschrieben, wie auf einer Druckplatte mittels UV-LED-Belichtung sowohl FTDs als auch RTDs erzeugt werden können. Hier wird die Druckplatte ein erstes Mal mit einem Laser beschrieben und dann so belichtet, dass FTDs entstehen. Anschließend wird die Druckplatte ein zweites Mal mit einem Laser beschrieben und dann so belichtet, dass RTDs entstehen. Allerdings ist das Verfahren sehr aufwendig und hat sich deshalb in der Praxis nicht durchgesetzt.

In der US 8,578,854 wird die UV-LED-Belichtung von Flexodruckplatten beschrieben, bei der sich die UV-LED-Belichtungseinheit in einem Reflektortunnel befindet. In dem Reflektortunnel wird die UV-LED-Strahlung zusätzlich gestreut, wodurch sich Rasterpunkte mit breiterer Versockelung realisieren lassen. Das Verfahren lässt sich für flache und runde Druckformen realisieren. Wie die Belichtung gesteuert werden soll, um Probleme wie das Dot-Bridging zu eliminieren, ist dem Dokument nicht zu entnehmen.

Schließlich beschreibt die WO 2014/035566 eine Flexodruckplatte, die mittels UV-LEDs belichtet wird, wobei die Belichtung mit zwei unterschiedlichen Wellenlängen (365 nm und 395 nm) erfolgt. Diese Art der Belichtung soll es ermöglichen, die Versockelung und den Flankenwinkel der Rasterpunkte zu steuern, um ein gutes Druckergebnis zu erreichen. Die Belichtung mittels zweier UV-LED-Leisten ist aber teuer. Wie das Problem des Dot-Bridging im Rasterdruck behoben werden kann, ist dem Dokument nicht zu entnehmen.

Aufgabe der Erfindung ist es, ein kostengünstiges Verfahren zur Herstellung von Flexodruckformen bereitzustellen, das den Nachteilen des Standes der Technik abhilft. Aufgabe der Erfindung ist es insbesondere, ein Verfahren bereitzustellen, mit dem laserbebilderbare Flexodruckplatten mittels UV-LED-Belichtung zu druckenden FTD-Klischees verarbeitet werden können, die eine hohe Auflösung und daher einen hohen Kontrast des Druckbildes und eine gute Farbübertragung durch Oberflächenstrukturen ermöglichen, ohne dass die typischen negativen Erscheinungsmerkmale der FTD-Klischees wie Ausbildung von Farbbrücken im Rasterdruck (das sogenannte Dot-Bridging) in Erscheinung treten.

Gelöst wird die Aufgabe durch ein Verfahren zur Herstellung von Flexodruckformen, bei dem man als Ausgangsmaterial ein fotopolymerisierbares Flexodruckelement einsetzt, welches übereinander angeordnet mindestens umfasst:
- einen dimensionsstabilen Träger, und
- mindestens eine fotopolymerisierbare reliefbildende Schicht, mindestens umfassend ein elastomeres Bindemittel, eine ethylenisch ungesättigte Verbindung und einen Fotoinitiator,
eine digital bebilderbare Schicht,
und das Verfahren mindestens die folgenden Schritte umfasst:
(a) Erzeugung einer Maske durch Bebilderung der digital bebilderbaren Schicht,
(b) Belichtung der fotopolymerisierbaren reliefbildenden Schicht durch die Maske hindurch mit aktinischem Licht und Fotopolymerisation der Bildbereiche der Schicht, und
(c) Entwicklung der fotopolymerisierten Schicht durch Auswaschen der nicht fotopolymerisierten Bereiche der reliefbildenden Schicht mit einem organischen Lösungsmittel oder durch thermische Entwicklung,
dadurch gekennzeichnet, dass der Schritt (b) zwei oder mehr Belichtungszyklen (b-1) und (b-n) mit aktinischem Licht mit einer Intensität von 100 bis 10 000 mW/cm² aus einer Mehrzahl von UV-LEDs umfasst, wobei die pro Belichtungszyklus in die fotopolymerisierbare reliefbildende Schicht eingetragene Energie 0,1 bis 5 J/cm² beträgt. Es wurde gefunden, dass bei der Belichtung der fotopolymerisierbaren Schicht mit hoher Belichtungsintensität mittels UV-LEDs das sogenannte "Cupping" der Rasterpunkte der druckenden Reliefschicht minimiert und die Zwischentiefen zwischen den Rasterpunkten vergrößert werden können, wenn die gesamte Belichtungsenergie nicht in einem einzigen Belichtungsschritt eingetragen wird, sondern auf mehrere Belichtungszyklen verteilt wird.

Die in der Summe in die fotopolymerisierbare Schicht eingetragene Energie (J/cm²) wird entsprechend der Reaktivität der Druckplatte eingestellt. Typische Energien, die zur Vernetzung einer Flexodruckplatte notwendig sind, liegen im Bereich von 5 - 25 J/cm².

In einer bevorzugten Ausführungsform der Erfindung beträgt die in Schritt (b) in die fotopolymerisierbare reliefbildende Schicht insgesamt eingetragene Energie 5 bis 25 J/cm².

Erfindungsgemäß wird diese Energie nicht in einem Belichtungsschritt in die fotopolymerisierbare Schicht eingetragen, sondern auf mehrere Teilbelichtungen (Belichtungszyklen) verteilt, bevorzugt werden mindestens 3 Teilbelichtungen durchgeführt.

In einer Ausführungsform der Erfindung bleibt die pro Belichtungszyklus eingetragene Energie über die Gesamtdauer des Belichtungsschritts (b) konstant.

Beispielsweise werden 10 bis 50 Belichtungszyklen mit einem Energieeintrag von 0,1 bis 1 J/cm² durchgeführt.

In einer bevorzugten Ausführungsform nimmt die pro Belichtungszyklus eingetragene Energie über die Gesamtdauer des Belichtungsschrittes (b) zu, das heißt in einem späteren Belichtungszyklus wird eine höhere Energie eingetragen als in einem früheren Belichtungszyklus.

In einer bevorzugten Ausführungsform werden zuerst mehrere Belichtungszyklen mit niedrigem Energieeintrag und anschließend ein oder mehrere Belichtungszyklen mit höherem Energieeintrag durchgeführt.

Beispielsweise werden zuerst 10 bis 40 Belichtungszyklen mit einem Energieeintrag von 0,1 bis 1 J/cm² und anschließend 1 bis 5 Belichtungszyklen mit 2 bis 5 J/cm² durchgeführt.
Im Allgemeinen weisen die in Schritt (b) eingesetzten UV-LEDs ein Emissionsmaximum im Wellenlängenbereich von 350 - 405 nm, beispielsweise bei 350 nm, 365 nm, 375 nm, 385 nm, 395 nm oder 405 nm auf.

Vorzugsweise werden die einzelnen Belichtungszyklen (b-1) bis (b-n) dadurch realisiert, dass die Mehrzahl der UV-LEDs parallel zur Oberfläche des Flexodruckelements bewegt wird. Bevorzugt ist dabei die Mehrzahl der UV-LEDs auf einer oder mehreren LED-Leisten angeordnet, die parallel zur Oberfläche des Flexodruckelements bewegt werden. Dabei können die LED-Leiste bzw. Leisten beweglich sein oder die LED-Leisten feststehend und die Oberfläche des Flexodruckelements beweglich sein, oder es können beide Möglichkeiten realisiert sein.

In einer Ausführungsform der Erfindung ist die Mehrzahl der UV-LEDs auf mindestens zwei UV-LED-Leisten nebeneinander angeordnet, von denen mindestens eine beweglich und mindestens eine feststehend ist.

Im Allgemeinen wird die UV-LED-Leiste mit einer Relativgeschwindigkeit von 50 bis 5000 mm/min parallel zur Oberfläche des Flexodruckelements bewegt.

Die Belichtungsschritte (b) werden vorzugsweise auf einem XY-Tisch mit einer Breite X und einer Länge Y mittels einer oder mehrerer UV-LED-Leisten, die entlang der Oberfläche des Flexodruckelements bewegt werden, vorgenommen. Die UV-LED-Leiste bzw. Leisten erstrecken sich üblicherweise über die Breite des XY-Tisches und deckt somit die gesamte Breite des Belichters ab. Während der Belichtung wird die UV-LED-Leiste mit variabler Geschwindigkeit mehrmals in Längsrichtung über die gesamte Länge der Druckplatte hin und her bewegt. Deren Länge kann beispielsweise 2 m betragen. Dabei erfolgt in einer Ausführungsform der Erfindung eine Belichtung nur beim Verfahren der UV-LED-Leiste in einer Richtung. In einer weiteren Ausführungsform der Erfindung erfolgt eine Belichtung beim Verfahren der UV-LED-Leiste in beide Richtungen (Hin- und Rückrichtung).

Die Leistung der UV-LED-Leiste liegt vorzugsweise in einem Bereich von 500 bis 5000 mW/cm², besonders bevorzugt in einem Bereich von 600 bis 2000 mW/cm². Diese wird mit einem UVA-Meter in einem Abstand von 10 mm zwischen Messsensor und Schutzfenster der LED-Leiste bestimmt. Dazu wird der Messsensor auf der Grundplatte des Belichters positioniert und von der Licht emittierenden UV-LED-Leiste überfahren, wobei ein Intensitätsprofil aufgezeichnet wird, dessen Maximum der Belichtungsintensität entspricht. Die an der Oberfläche des Flexodruckelements eingestrahlte Lichtleistung ist bei größerem Abstand zwischen UV-LED-Leiste und bestrahlter Oberfläche entsprechend geringer und bei kleinerem Abstand zwischen UV-LED-Leiste und bestrahlter Oberfläche entsprechend höher. Erfindungsgemäß liegt die an der Oberfläche des Flexodruckelements eingestrahlte Leistung (Lichtintensität) bei 100 bis 5000 mW/ cm², bevorzugt bei 500 bis 5000 mW/cm² und besonders bevorzugt bei 600 bis 2000 mW/cm².

Mögliche Wellenlängen sind 355 nm, 365 nm, 375 nm, 395 nm, 405 nm, bevorzugte Wellenlänge ist 365 nm.

Eine typische UV-LED-Leiste besitzt eine Strahlfensterbreite von etwa 10 mm und ist aus linear angeordneten LED-Arrays, bestehend aus jeweils 4 LEDs in quadratischer Anordnung, aufgebaut, so dass eine gleichmäßige Lichtintensität über die gesamte Länge der LED-Leiste emittiert wird.

In einer typischen, 1 m langen LED-Leiste sind beispielsweise insgesamt 125 LED-Arrays, entsprechend 500 einzelnen LEDs, angeordnet.

Die UV-LED-Arrays können auch versetzt angeordnet sein, um eine größere Fläche zu bestrahlen. Die UV-LED-Leiste muss dann allerdings verspiegelt werden, bevorzugt an den Seiten, um eine gleichmäßige Ausleuchtung der bestrahlten Fläche sicherzustellen. Die UV-LED-Leiste strahlt üblicherweise Licht mit einem gewissen Abstrahlwinkel ab. Typische Abstrahlwinkel liegen in einem Bereich von 20 bis 70 Grad, bei linear aufgebauten UV-LED-Leisten in einem Bereich von 20 bis 40 Grad. Aus der Strahlfensterbreite, dem Abstrahlwinkel und dem Abstand der LED-Leiste zur Druckplattenoberfläche kann die Breite des bestrahlten Flächenelementes berechnet werden.

Üblicherweise liegt der Abstand der Leiste von der Druckplattenoberfläche bei 5 mm bis 100 mm, bevorzugt bei 5 bis 30 mm.

Bei einer üblichen UV-LED-Leiste mit einer Strahlfensterbreite von etwa 10 mm liegt die Breite des bestrahlten Flächenelementes in einem Bereich von 15 bis 100 mm, bei niedrigem Abstand von ca. 10 mm zur Plattenoberfläche zwischen 15 und 40 mm.
Die Geschwindigkeit, mit der die UV-LED-Leiste relativ zur Oberfläche des Flexodruckelements bewegt wird, liegt im Bereich von 50 mm/min bis 10 000 mm/min, bevorzugt von 100 mm/min bis 5 000 mm/min.

In einer weiteren, bevorzugten Ausführungsform der Erfindung wird die UV-LED-Leiste in den Belichtungszyklen mit niedrigem Energieeintrag hin und her verfahren und nicht beim Zurückfahren in die Ausgangsposition abgeschaltet, und anschließend bei den Belichtungszyklen mit hohem Energieeintrag nur in eine Richtung verfahren, also beim Zurückfahren in die Ausgangsposition abgeschaltet. Hierdurch kann die Belichtungszeit insgesamt wesentlich reduziert werden.

Aus der Geschwindigkeit der UV-LED-Leiste relativ zur Plattenoberfläche und der Breite des bestrahlten Flächenelementes der Plattenoberfläche kann die Bestrahlungsdauer ermittelt werden. Mit der mittels eines UVA-Messgerätes ermittelten mittleren Leistung der UV-LED-Strahlung kann dann der Energieeintrag pro Belichtungszyklus ermittelt werden.

So beträgt beispielsweise bei einer UVA-Leistung eines LED-Belichters von 800 mW/cm², einer Breite des bestrahlten Flächenelementes von 25 mm und einer typischen Vorschubgeschwindigkeit von 250 mm/min die Bestrahlungsdauer 6 Sekunden und der Energieeintrag 4,8J/cm².

Bei der Bestrahlung von Flexodruckplatten mittels UV-LED-Leisten in dem genannten Leistungsbereich kann es zu einer lokalen, starken Erwärmung der Druckplatte kommen. Insbesondere bei langsamer Fahrweise und hoher Leistung können in der Druckplatte kurzfristig Temperaturen von bis zu 80°C erreicht werden. Um den Temperaturanstieg zu begrenzen, ist es vorteilhaft, zwischen LED-Leiste und Druckplattenoberfläche einen Luftrakel zur Kühlung vorzusehen. Ferner sollte die Grundplatte des Belichters gekühlt werden können, um die durch Absorption und chemische Reaktion erzeugte Wärme wieder schnell abführen zu können.

Natürlich ist die erfindungsgemäße UV-LED-Belichtung in mehreren Teilbelichtungsschritten (Belichtungszyklen) nicht auf Ausführungsformen beschränkt, in denen die Druckplatte fest auf dem XY-Tisch verbleibt und sich die UVA-LED-Leiste darüber hinweg bewegt.

Insbesondere in einer automatischen Plattenverarbeitungsanlage, in der die Druckplatte mit konstanter Geschwindigkeit transportiert wird und die einzelnen Verarbeitungsschritte durchläuft, wird man die einzelnen Belichtungszyklen mit mehreren fest stehenden UVA-LED-Leisten realisieren, unter denen die Platte hindurchläuft.

In einer weiteren Variante wird die Druckplatte mit einer konstanten Geschwindigkeit transportiert, und die UVA-LED-Leiste wird in Transportrichtung mit einer höheren Geschwindigkeit als der Transportgeschwindigkeit hin und her verfahren, um Belichtungszyklen mit geringem Energieeintrag zu realisieren. Anschließend wird die UVA-LED-Leiste in eine stationäre Position am Ende der Belichtungsstrecke verfahren, in der ein Belichtungszyklus mit höherem Energieeintrag realisiert wird. Da eine UV-LED-Leiste in ihrer Leistung nahezu stufenlos regelbar ist, sind hier zahlreiche Varianten möglich.

Alternativ können die Teilbelichtungen mit niedriger Energie auch derart realisiert werden, dass eine UVA-LED-Leiste längs zur Bahnrichtung angebracht ist und hin- und her bewegt wird, und am Ende der Belichtungsstrecke dann eine zweite oder dritte UVA-LED-Leiste quer zur Transportrichtung durchlaufen wird.

Die in der Druckplatte ablaufenden Vorgänge bei Bestrahlung mit UVA-Licht sind komplex. Es laufen mehrere Vorgänge parallel ab, die in drei Dimensionen zu berücksichtigen sind, um die Entstehung der für den späteren Druck optimalen Rasterpunktgeometrie erklären und beeinflussen zu können.

Nach Absorption des UVA-Lichtes zerfällt ein in der Druckplatte vorhandenes Fotoinitiatormolekül in zwei Radikale. Die entstehenden Radikale reagieren in einer radikalischen Kettenreaktion mit dem in der Druckplatte vorhandenen niedermolekularen Vernetzer. Da der Vernetzer multifunktionell ist, kommt es durch die Polymerisation zur Ausbildung von Netzwerken, die zur Unlöslichkeit der belichteten Bereiche der Druckplatte führen. Die Geschwindigkeit der Fotopolymerisation ist in der Regel sehr schnell und in erster Näherung von der Konzentration des zur Verfügung stehenden Vernetzers und der zur Verfügung stehenden Radikale abhängig.

Radikalische Kettenreaktionen werden durch Anwesenheit von Sauerstoff inhibiert, da Sauerstoff reaktive Radikale abfängt und in stabilere Radikale, die für die weitere Polymerisation nicht mehr zur Verfügung stehen, umwandelt.
Bei einer typischen Röhrenbelichtung wird die Druckplatte für eine Zeit von ca. 10 Minuten mit UVA-Licht niedriger Leistung (ca. 20mW/cm²) bestrahlt. Bei dieser niedrigen Leistung liegt die Geschwindigkeit der Kettenstartreaktion in derselben Größe wie die Geschwindigkeit der Kettenabbruchreaktion. In den belichteten Bereichen der Druckplatte läuft daher als Konkurrenzreaktion zu der durch Radikalbildung gestarteten Polymerisation die Abbruchsreaktion mit Sauerstoff ab. An der Oberfläche der Druckplatte kann Sauerstoff aus der Umgebungsluft nachdiffundieren. Deshalb werden Rasterpunkte bei der Röhrenbelichtung an der Oberfläche der Druckplatte üblicherweise nicht exakt abgebildet, sondern weisen abgerundete Punktoberflächen auf. Der Fachmann spricht von sogenannten Round-Top-Dots (RTD).

Bei der UV-LED-Belichtung werden höhere Strahlungsdosen in sehr viel kürzerer Zeit in die Platte eingetragen. Bei einer typischen UV-LED-Belichtung liegt die abgestrahlte Leistung bei ca. 1000 mW/cm². Bei einer üblichen Bestrahlungsbreite von etwa 30 mm und Vorschubgeschwindigkeiten von 100 bis 5 000 mm/min liegt die Belichtungszeit unter einer Minute, meist im Bereich weniger Sekunden. Unter diesen Bedingungen ist die Konzentration der durch Lichtabsorption erzeugten Radikale in den belichteten Bereichen der fotopolymerisierbaren Schicht um Größenordnungen höher als bei der Röhrenbelichtung. Die Kettenstartreaktion ist sehr viel schneller als die Kettenabbruchreaktion. Der in der fotopolymerisierbaren Schicht anwesende oder nachdiffundierende Sauerstoff kann die Fotopolymerisation nicht mehr wesentlich beeinflussen. Die Rasterpunkte werden daher exakt bis zur Grenze zum unbelichteten Bereich abgebildet. Es entstehen Rasterpunkte mit scharfen Rändern. Der Fachmann spricht von sogenannten Flat-Top-Dots (FTD).

Erfindungsgemäß erfolgt die Belichtung so, dass FTD-Rasterpunkte entstehen. Die Kettenstartreaktion ist sehr viel schneller als die durch Sauerstoff bewirkte Kettenabbruchreaktion. Trotzdem spielen die Gegenwart von der Sauerstoff und dessen Nachdiffusion immer noch eine erhebliche Rolle an der Grenze zwischen belichteten und unbelichteten Bereichen der Druckplatte.

Ohne an eine bestimmte Theorie gebunden zu sein wird vermutet, dass unter UV-LED-Belichtungsbedingungen ein weiterer Effekt zu berücksichtigen ist. Durch die hohe Belichtungsintensität kommt es in den belichteten Bereichen der Druckplatte zu einer schlagartigen Abreicherung des Vernetzers. Die Reaktion läuft anschließend diffusionskontrolliert ab und wird durch Diffusion des Vernetzers aus den benachbarten, nicht belichteten Bereichen gespeist. Die Diffusion des Vernetzers ist aber vergleichsweise langsam und wirkt sich daher nur in einem engen Bereich um die Grenze von Bild- zu Nichtbildbereichen aus. Aus den vorliegend durchgeführten Untersuchungen kann geschlossen werden, dass Diffusionseffekte nur in einem Abstand von wenigen µm (10 bis 100 µm) um die belichteten Bereiche herum eine wesentliche Rolle spielen. Durch die Diffusion des Vernetzers kommt es an der Grenze zwischen unbelichteten und belichteten Bereichen der Druckplatte zu einem signifikanten Materialtransport, der die Punktform des Rasterpunktes und insbesondere die Ränder des Rasterpunktes wesentlich bestimmt. Das Phänomen der Ausbildung von messbaren Rändern an den Grenzen der Bildelemente ist dem Fachmann bekannt. Er spricht vom Cupping. Der Zusammenhang des sogenannten Cuppings mit der Diffusion des Vernetzers in der photopolymerisierbaren Schicht wurde bislang aber nicht erkannt.

Somit konkurrieren bei der Belichtung von Flexodruckplatten mit energiereicher UV-LED-Strahlung die Prozesse (1) Lichtabsorption und Radikalbildung, (2) Polymerisation, (3) Diffusion von Sauerstoff in die fotopolymerisierbare Schicht und Kettenabbruch sowie (4) Diffusion des Vernetzers in der fotopolymerisierbaren Schicht miteinander und bestimmen im Zusammenspiel die Form der Reliefelemente und damit auch deren Druckverhalten.

Zur Messung der Lichtintensität auf Höhe der Oberfläche des Flexodruckelements wird ein geeignetes, kalibriertes UV-Messgerät verwendet, wobei der Sensor des Messgeräts im gleichen Abstand von der Strahlungsquelle platziert wird, den die Plattenoberfläche von der Strahlungsquelle haben würde. Geeignete UV-Messgeräte sind im Handel von verschiedenen Anbietern erhältlich. Wichtig hierbei ist, dass das Messgerät im zu prüfenden UV-Wellenlängenbereich sensitiv und kalibriert ist.

Bei der Herstellung von zylindrischen Flexodruckformen können auch so genannte Rundbelichter eingesetzt werden, wobei diese dann ein oder mehrere LED-Arrays umfassen.

Im Allgemeinen wird eine Rückseitenvorbelichtung des Flexodruckelements durchgeführt. Dazu wird die Schicht aus fotopolymerisierbarem Material vor Durchführung von Schritt (b) von der Rückseite des fotopolymerisierbaren Flexodruckelements durch die UVtransparente Trägerfolie hindurch mit aktinischem Licht vorbelichtet. Die Rückseitenvorbelichtung wird vorzugsweise bei Flexodruckelementen mit einer Stärke von ≥ 1 mm durchgeführt, wobei diese Angabe sich auf die Summe aus dimensionsstabiler Trägerfolie und fotopolymerisierbarer Schicht bezieht.

Im Allgemeinen erfolgt die Rückseitenvorbelichtung mit einer UV-Röhre oder einem UV-Strahler.

Das als Ausgangsmaterial eingesetzte fotopolymerisierbare Flexodruckelement umfasst übereinander angeordnet mindestens
- einen dimensionsstabilen Träger, und
- mindestens eine fotopolymerisierbare reliefbildende Schicht, mindestens umfassend ein elastomeres Bindemittel, eine ethylenisch ungesättigte Verbindung und einen Fotoinitiator,
- eine durch Laserablation digital bebilderbare Schicht.

Beispiele geeigneter dimensionsstabiler Träger für die als Ausgangsmaterial für das Verfahren eingesetzte fotopolymerisierbare Flexodruckelemente sind Platten, Folien sowie konische und zylindrische Röhren (Sleeves) aus Metallen wie Stahl, Aluminium, Kupfer oder Nickel oder aus Kunststoffen wie Polyethylenterephthalat (PET), Polyethylennaphthalat (PEN), Polybutylenterephthalat (PBT), Polyamid, Polycarbonat, gegebenenfalls auch Gewebe und Vliese, wie Glasfasergewebe, sowie Verbundmaterialien, z.B. aus Glasfasern und Kunststoffen. Als dimensionsstabile Träger kommen vor allem dimensionsstabile Trägerfolien wie beispielsweise Polyesterfolien, insbesondere PET- oder PEN-Folien oder flexible metallische Träger, wie dünne Bleche oder Metallfolien aus Stahl, bevorzugt aus rostfreiem Stahl, magnetisierbarem Federstahl, Aluminium, Zink, Magnesium, Nickel, Chrom oder Kupfer in Betracht.

Soll eine Rückseitenvorbelichtung des Flexodruckelements durchgeführt werden, muss der dimensionsstabile Träger für UV-Licht transparent sein. Bevorzugte Träger sind Kunststofffolien aus PET oder anderen Polyestern.

Das Flexodruckelement umfasst weiterhin mindestens eine fotopolymerisierbare, reliefbildende Schicht. Die fotopolymerisierbare reliefbildende Schicht kann unmittelbar auf dem Träger aufgebracht sein. Zwischen dem Träger und der reliefbildenden Schicht können sich aber auch noch andere Schichten befinden, wie beispielsweise Haftschichten und/oder elastische Unterschichten.
Zwischen der gegebenenfalls mit einer Haftschicht beschichteten Trägerfolie und der fotopolymerisierbaren, reliefbildenden Schicht kann sich eine elastomere Trägerschicht befinden. Die Trägerschicht kann optional kompressibel oder fotochemisch vernetzbar sein.

Die fotopolymerisierbare reliefbildende Schicht umfasst mindestens ein elastomeres Bindemittel, eine ethylenisch ungesättigte Verbindung, einen Fotoinitiator oder ein Fotoinitiatorsystem sowie optional eine oder mehrere weitere Komponenten, beispielsweise Weichmacher, Verarbeitungshilfsmittel, Farbstoffe und UV-Absorber.

Elastomere Bindemittel zur Herstellung von Flexodruckelementen sind dem Fachmann bekannt. Es können sowohl hydrophile als auch hydrophobe Bindemittel eingesetzt werden. Als Beispiele seien Styrol-Dien-Blockcopolymere, Ethylen-Acrylsäure-Copolymere, Polyethylenoxid-Polyvinylalkohol-Pfropfcopolymere, Naturkautschuk, Polybutadien, Polyisopren, Styrol-Butadien-Kautschuk, Nitril-Butadien-Kautschuk, ButylKautschuk, Styrol-Isopren-Kautschuk, Styrol-Butadien-Isopren-Kautschuk, Polynorbornen-Kautschuk oder Ethylen-Propylen-Dien-Kautschuk (EPDM) genannt. Bevorzugt werden hydrophobe Bindemittel eingesetzt. Derartige Bindemittel sind in organischen Lösemitteln löslich oder zumindest quellbar, während sie in Wasser weitgehend unlöslich sind und auch nicht oder zumindest nicht wesentlich in Wasser quellbar sind.

Bevorzugt handelt es sich bei dem Elastomer um ein thermoplastisch elastomeres Blockcopolymer aus Alkenylaromaten und 1,3-Dienen. Bei den Blockcopolymeren kann es sich sowohl um lineare, verzweigte oder radiale Blockcopolymere handeln. Üblicherweise handelt es sich um Dreiblockcopolymere vom A-B-A-Typ, es kann sich aber auch um Zweiblockpolymere vom A-B-Typ handeln, oder um solche mit mehreren alternierenden elastomeren und thermoplastischen Blöcken, z.B. A-B-A-B-A. Es können auch Gemische zweier oder mehrerer unterschiedlicher Blockcopolymere eingesetzt werden. Handelsübliche Dreiblockcopolymere enthalten häufig gewisse Anteile an Zweiblockcopolymeren. Die Dien-Einheiten können 1,2- oder 1,4-verknüpft sein. Es können sowohl Blockcopolymere vom Styrol-Butadien oder vom Styrol-Isopren-Typ, als auch vom Styrol-Butadien-Isopren-Typ eingesetzt werden. Sie sind beispielsweise unter dem Namen Kraton® im Handel erhältlich. Weiterhin einsetzbar sind auch thermoplastisch elastomere Blockcopolymere mit Endblöcken aus Styrol und einem statistischen Styrol-Butadien-Mittelblock, die unter dem Namen Styroflex® erhältlich sind. Die Blockcopolymere können auch ganz oder teilweise hydriert sein, wie beispielsweise in SEBS-Kautschuken.

Ganz besonders bevorzugt in der fotopolymerisierbaren reliefbildenden Schicht enthaltene elastomere Bindemittel sind Dreiblockcopolymere vom Typ A-B-A oder radiale Blockcopolymere vom Typ (AB)ₙ, worin A Styrol und B ein Dien sind.

Ganz besonders bevorzugt in einer elastomeren Trägerschicht enthaltene elastomere Bindemittel sind Dreiblockcopolymere vom Typ A-B-A, radiale Blockcopolymere vom Typ (AB)ₙ, worin A Styrol und B ein Dien sind, sowie statistische Copolymere und Random-Copolymere aus Styrol und einem Dien.

Selbstverständlich können auch Gemische mehrerer Bindemittel eingesetzt werden, vorausgesetzt, die Eigenschaften der reliefbildenden Schicht werden dadurch nicht negativ beeinflusst.

Die Gesamtmenge an Bindemitteln beträgt im Falle der reliefbildenden Schicht üblicherweise 40 bis 90 Gew.-% bezüglich der Summe aller Bestandteile der reliefbildenden Schicht, bevorzugt 40 bis 80 Gew.-% und besonders bevorzugt 45 bis 75 Gew.-%.

Im Falle einer gegebenenfalls vorhandenen elastomeren Trägerschicht kann die Gesamtmenge an elastomeren Bindemitteln bis zu 100 Gew.-% betragen. Üblicherweise beträgt sie 75 bis 100 Gew.-%, bevorzugt 85 bis 100 Gew.-% und besonders bevorzugt 90 bis 100 Gew.-%.

Die fotopolymerisierbare reliefbildende Schicht umfasst weiterhin in bekannter Art und Weise mindestens eine ethylenisch ungesättigte Verbindung, die mit den Bindemitteln verträglich ist. Geeignete Verbindungen weisen mindestens eine ethylenisch ungesättigte Doppelbindung auf und sind polymerisierbar. Diese werden daher nachfolgend als Monomere bezeichnet. Als besonders vorteilhaft haben sich Ester oder Amide der Acrylsäure oder Methacrylsäure mit mono- oder polyfunktionellen Alkoholen, Aminen, Aminoalkoholen oder Hydroxyethern und -estern, Ester der Fumar- oder Maleinsäure, Vinylether, Vinylester oder Allylverbindungen erwiesen. Beispiele für geeignete Monomere sind Butylacrylat, 2-Ethylhexylacrylat, Laurylacrylat, Tetradecylacrylat, 1,4-Butandioldiacrylat, 1,6-Hexandioldiacrylat, 1,6-Hexandioldimethacrylat, 1,9-Nonandioldiacrylat, Trimethylolpropantri(meth)acrylat, Dioctylfumarat und N-Dodecylmaleimid. Ganz besonders bevorzugte Monomere sind Mono-, Di- und Triacrylate sowie -methacrylate. Selbstverständlich können auch Gemische mehrerer verschiedener Monomere eingesetzt werden. Art und Menge der Monomeren werden vom Fachmann je nach den gewünschten Eigenschaften der Schicht gewählt. Die Menge an Monomeren beträgt in der fotopolymerisierbaren reliefbildenden Schicht a) im Regelfalle nicht mehr als 20 Gew.-% bzgl. der Menge aller Bestandteile, im Allgemeinen liegt sie zwischen 3 und 15 Gew.-%.

Die fotopolymerisierbare reliefbildende Schicht umfasst weiterhin in prinzipiell bekannter Art und Weise mindestens einen Fotoinitiator oder ein Fotoinitiatorsystem. Beispiele für geeignete Initiatoren sind Benzoin oder Benzoinderivate, wie Methylbenzoin oder Benzoinether, Benzilderivate, wie Benzilketale, Acylarylphosphinoxide, Acylarylphosphinsäureester, α-Hydroxyketone, Mehrkernchinone oder Benzophenone. Die Menge an Fotoinitiator in der reliefbildenden Schicht beträgt in der Regel 0,1 bis 5 Gew.-% bezüglich der Menge aller Bestandteile der reliefbildenden Schicht.

Die elastomere Trägerschicht kann ebenfalls die genannten ethylenisch ungesättigten Verbindungen und die genannten Fotoinitiatoren enthalten, bevorzugt enthält sie diese, ist also wie die reliefbildende Schicht fotopolymerisierbar. Im Allgemeinen beträgt die Menge an ethylenisch ungesättigten Verbindungen in der Trägerschicht 0 bis 15 Gew.-%. Im Allgemeinen beträgt die Menge an Fotoinitiator in der Trägerschicht 0 bis 5 Gew.-%.

Die reliefbildende Schicht und gegebenenfalls die optionale elastomere Trägerschicht können Weichmacher enthalten. Es können auch Gemische verschiedener Weichmacher eingesetzt werden. Beispiele für geeignete Weichmacher umfassen modifizierte und unmodifizierte Naturöle und -harze, wie hochsiedende paraffinische, naphthenische oder aromatische Mineralöle, synthetische Oligomere oder Harze wie Oligostyrol, hochsiedende Ester, oligomere Styrol-Butadien-Copolymere, oligomere α-Methylstyrol/p-Methylstyrol-Copolymere, flüssige Oligobutadiene, insbesondere solche mit einem Molekulargewicht zwischen 500 und 5000 g/mol, oder flüssige oligomere AcrylnitrilButadien-Copolymere oder oligomere Ethylen-Propylen-Dien-Copolymere. Bevorzugt sind Polybutadienöle, insbesondere solche mit einem Molekulargewicht zwischen 500 und 5000 g/mol, hochsiedende aliphatische Ester wie insbesondere Alkylmono- und dicarbonsäureester, beispielsweise Stearate oder Adipate, und Mineralöle. Die Menge eines optional vorhandenen Weichmachers wird vom Fachmann je nach den gewünschten Eigenschaften der Schicht bestimmt. Sie wird im Regelfalle 50 Gew.-% der Summe aller Bestandteile der fotopolymerisierbaren reliefbildende Schicht nicht übersteigen, im Allgemeinen beträgt sie 0 bis 50 Gew.-%, bevorzugt 0 bis 40 Gew.-%.

Die Dicke der reliefbildenden Schicht beträgt im Allgemeinen 0,3 bis 7 mm, bevorzugt 0,5 bis 6 mm.

In einer bevorzugten Ausführungsform wird ein Bindemittel vom Styrol-Butadien-Typ eingesetzt. Besonders bevorzugte Bindemittel sind lineare, radiale oder verzweigte Blockcopolymere vom Styrol-Butadien-Typ. Diese Blockcopolymere haben ein mittleres Molekulargewicht M_{w} (Gewichtsmittel) von 80 000 bis 250 000 g/mol, bevorzugt 80 000 bis 150 000 g/mol, und besonders bevorzugt von 90 000 bis 130 000 g/mol und weisen einen Styrolgehalt von 20 bis 40 Gew.-%, bevorzugt von 20 bis 35 Gew.-% und besonders bevorzugt von 20 bis 30 Gew.-% auf.

In einer weiteren bevorzugten Ausführungsform der Erfindung handelt es sich um ein Bindemittel vom Styrol-Isopren-Typ. Bevorzugte Bindemittel vom Styrol-Isopren-Typ enthalten in der Regel 13 bis 40 Gew.-%, bevorzugt 13 bis 35 Gew.-% und besonders bevorzugt von 14 bis 30 Gew.-% Styrol.

Die fotopolymerisierbaren Flexodruckelemente lassen sich nach dem Fachmann prinzipiell bekannten Methoden herstellen, beispielsweise durch Schmelzextrusion, Gießen oder Laminieren in einem einstufigen oder mehrstufigen Produktionsprozess. Bevorzugt ist die Herstellung mittels Schmelzextrusion, bei dem man zunächst die Bestandteile der reliefbildenden Schicht in einem Extruder unter Erwärmen miteinander mischt. Zur Herstellung von flächenförmigen Flexodruckelementen kann die fotopolymerisierbare Masse aus dem Extruder durch eine Breitschlitzdüse zwischen zwei Folien ausgetragen und der Schichtenverbund kalandriert werden, wobei sich die Art der Folien nach dem gewünschten Verwendungszweck richtet. Es kann sich hierbei um Folien handeln, welche eine gute Haftung mit der fotopolymerisierbaren Schicht aufweisen oder um leicht abziehbare (temporäre) Folien. Zur Herstellung von flächenförmigen Flexodruckelementen wird üblicherweise eine gut haftende Trägerfolie und eine abziehbare Deckfolie eingesetzt. Die Dicke der fotopolymerisierbaren Schicht beträgt im Allgemeinen 0,4 bis 7 mm, bevorzugt 0,5 bis 4 mm und besonders bevorzugt 0,7 bis 2,5 mm.

Die Bebilderung der digital bebilderbaren Schicht wird mittels digitaler Masken vorgenommen. Derartige Masken sind auch als In-situ-Masken bekannt. Hierzu wird zunächst eine digital bebilderbare Schicht auf die fotopolymerisierbare, reliefbildende Schicht aufgebracht. Bevorzugt handelt es sich bei der digital bebilderbaren Schicht um eine IR-ablative Schicht, Ink-Jet-Schicht oder thermografisch beschreibbare Schicht. Bevorzugt ist die digital bebilderbare Schicht eine mit einem IR-Laser ablatierbare (IR-ablative) Schicht.

IR-ablative Schichten bzw. Masken sind für die Wellenlänge des aktinischen Lichtes opak und umfassen üblicherweise mindestens ein Bindemittel, einen IR-Absorber wie beispielsweise Ruß sowie einen Absorber für UV-Strahlung, wobei die Funktion des IR-Absorbers und UV-Absorbers auch von nur einem Stoff ausgeübt werden kann, was beispielsweise bei der Verwendung von Ruß als IR-Absorber der Fall ist, da Ruß in ausreichender Konzentration die Maskenschicht für UV-Licht im Wesentlichen undurchlässig macht. In die IR-ablative Schicht kann mittels eines IR-Lasers eine Maske eingeschrieben werden, d.h. die Schicht wird an den Stellen, an denen sie vom Laserstrahl getroffen wird, zersetzt und abgetragen. Durch die entstandene Maske hindurch kann bildmäßig mit aktinischem Licht bestrahlt. werden. Beispiele für die Bebilderung von Flexodruckelementen mit IR-ablativen Masken sind beispielweise in EP-A 654 150 oder EP-A 1 069 475 offenbart.

Bei Ink-Jet-Schichten wird eine mit Ink-Jet-Tinten beschreibbare Schicht, beispielsweise eine Gelatine-Schicht aufgetragen. Diese ist mittels Ink-Jet-Druckern bebilderbar. Beispiele sind in EP-A 1 072 953 offenbart.

Bei thermografischen Schichten handelt es sich um Schichten, die Substanzen enthalten, die sich unter dem Einfluss von Hitze schwarz färben. Derartige Schichten umfassen beispielsweise ein Bindemittel und ein organisches Silbersalz und können mittels eines Druckers mit Thermokopf oder mittels IR-Lasern bebildert werden. Beispiele sind in EP-A 1 070 989 offenbart.

Das erfindungsgemäße Verfahren kann durchgeführt werden, indem das Ausgangsmaterial zunächst in eine Aufnahmeeinheit eingelegt wird, beispielsweise durch Auflegen auf ein Förderband oder Bestücken des Magazins. Falls das Ausgangsmaterial eine Schutzfolie aufweist, muss diese für den Fall, dass die Aufnahmeeinheit keine automatische Abzugsvorrichtung aufweist, abgezogen werden.
In dem Verfahrensschritt (a) wird die digital bebilderbare Schicht in einer Bebilderungseinheit mittels der jeweils erforderlichen Technik bebildert. Die Bildinformationen werden direkt einer Steuerungseinheit entnommen.

In dem Verfahrensschritt (b) wird das bebilderte Flexodruckelement mittels der Belichtungseinheit durch die erzeugte Maske hindurch mittels aktinischem, also chemisch wirksamem Licht bestrahlt.

In einem Verfahrensschritt (c) wird das bildmäßig bebilderte und belichtete Flexodruckelement mittels eines geeigneten Lösemittels oder einer Lösemittelkombination entwickelt. Hierbei werden die nicht belichteten, d.h. die von der Maske abgedeckten Bereiche der Reliefschicht entfernt, während die belichteten, d.h. die vernetzten Bereiche erhalten bleiben. Außerdem werden die Reste der digital bebilderbaren Schicht entfernt.

Das verwendete Lösungsmittel bzw. Lösungsmittelgemisch richtet sich nach der Art des eingesetzten Flexodruckelementes. Falls das Flexodruckelement eine wässrig entwickelbare fotopolymerisierbare Schicht aufweist, können Wasser oder überwiegend wässrige Lösemittel eingesetzt werden. Für den Fall organisch entwickelbarer Flexodruckelemente eignen sich insbesondere die bekannten Auswaschmittel für Flexodruckplatten, die üblicherweise aus Gemischen verschiedener organischer Lösungsmittel bestehen, die auf geeignete Art und Weise zusammenwirken. Beispielsweise können Entwickler aus naphthenischen oder aromatischen Erdölfraktionen im Gemisch mit Alkoholen, beispielsweise Benzylalkohol, Cyclohexanol oder aliphatische Alkohole mit 5 bis 10 Kohlenstoffatomen, sowie ggf. weiteren Komponenten, wie beispielsweise alicyclischen Kohlenwasserstoffen, Terpen-Kohlenwasserstoffen, substituierten Benzolen, beispielsweise Diisopropylbenzol, Estern mit 5 bis 12 Kohlenstoffatomen oder Glykolethern eingesetzt werden. Geeignete Auswaschmittel sind beispielsweise in EP-A 332 070 oder EP-A 433 374 offenbart.

Der Entwicklungsschritt wird üblicherweise bei Temperaturen oberhalb 20°C durchgeführt. Aus Sicherheitsgründen und zur Reduktion des apparativen Aufwands beim Entwicklungsgerät sollte die Temperatur bei der Verwendung organischer Lösemittel 5°C bis 15°C unter dem Flammpunkt des eingesetzten Auswaschmittelgemisches liegen.

Eine Trocknung der Flexodruckplatten kann in einem Verfahrensschritt (d) erfolgen. Weist das Flexodruckelement einen Träger aus einer PET-Folie auf, erfolgt eine Trocknung vorzugsweise bei einer Temperatur von 40 bis 80°C, besonders bevorzugt bei 50 bis 70°C. Handelt es sich bei dem dimensionsstabilen Träger des Flexodruckelements um einen Metallträger, kann die Trocknung auch bei höheren Temperaturen bis zu etwa 160°C erfolgen.

Die erhaltenen Flexodruckplatten können in einem Verfahrensschritt (e) bei Bedarf noch einer entklebenden Nachbehandlung durch UVA- und/oder UVC-Licht unterzogen werden. Im Regelfalle ist ein solcher Schritt empfehlenswert. Wenn die Bestrahlung mit Licht unterschiedlicher Wellenlänge vorgesehen ist, kann sie gleichzeitig oder auch nacheinander erfolgen.

Zwischen den einzelnen Verfahrensschritten wird das Flexodruckelement bzw. die Flexodruckplatte von einer Einheit zur nächsten weiter transportiert.

Die Entwicklung kann auch thermisch erfolgen. Bei der thermischen Entwicklung wird kein Lösemittel eingesetzt. Stattdessen wird die reliefbildende Schicht nach der bildmäßigen Belichtung mit einem absorbierenden Material in Kontakt gebracht und erwärmt. Bei dem absorbierenden Material handelt es sich beispielsweise um ein poröses Vlies, beispielsweise aus Nylon, Polyester, Cellulose oder anorganischen Materialien. Im Zuge der thermischen Entwicklung erfährt das Flexodruckelement zumindest an der Oberfläche eine derartige Temperaturerwärmung, dass sich die nicht polymerisierten Anteile der reliefbildenden Schicht verflüssigen und vom absorbierenden Material aufgenommen werden können. Das verbrauchte absorbierende Material wird anschließend entfernt. Einzelheiten zur thermischen Entwicklung sind beispielsweise von US 3,264,103, US 5,175,072, WO 96/14603 oder WO 01/88615 offenbart. Die Maske kann gegebenenfalls vorher mittels eines geeigneten Lösemittels oder ebenfalls thermisch entfernt werden.

Die Erfindung wird durch die nachfolgenden Beispiele näher erläutert.

### Beispiele

Die Figuren 1 bis 7 zeigen:
Figur 1 zeigt das Ergebnis der Perthometer-Messung für ein Klischee mit ausgeprägtem Cupping.
Figur 2 zeigt das Ergebnis der Perthometer-Messung für ein erfindungsgemäß hergestelltes Klischee mit minimalem Cupping.
Figur 3 zeigt eine elektronenmikroskopische Aufnahme von Rasterpunkten mit ausgeprägtem Cupping.
Figur 4 zeigt eine elektronenmikroskopische Aufnahme von Rasterpunkten mit erfindungsgemäß minimalem Cupping.
Figur 5 zeigt das in den Druckversuchen verdruckte Textmotiv.
Figur 6 zeigt die Druckkennlinien für die Druckversuche VV1 und V1 bis V6.
Figur 7 zeigt vergrößerte fotographische Aufnahmen von Punktrastern für die Druckversuche VV1, V3, V5 und V6.

### Messtechnische Ermittlung der hochstehenden Ränder

Die quantitative Erfassung der hochstehenden Ränder der Bildelemente eines Flexodruckklischees, insbesondere einzelner Rasterpunkte, ist nicht trivial. Die Ränder sind nur wenige µm hoch und mit optischen Methoden nur schwer zu ermitteln.

Eine einfache und schnelle Messmethode für die Geometrie von Rasterpunkt-Oberflächen ist das mechanische Abtasten der Oberfläche mittels eines Diamantfühlers, der an einem beweglichen Arm befestigt wird und dessen Auslenkung gemessen und in ein Oberflächenprofil umgerechnet wird (Perthometer-Messung). Um die Reproduzierbarkeit der Messergebnisse sicherzustellen, werden alle Messungen am selben Rasterfeld (Tonwert 40%, Linienweite 89 LPI) mit identischen Messbedingungen durchgeführt.

Für die Messungen wird ein MarSurf M400-Set der Firma Mahr mit einem Vorschubgerät SD26 und einem Tastsystem BFW-250 mit einer Messkraft von 0,7 mN bei einer Messtrecke von 5 mm verwendet. Die Geschwindigkeit bei dieser Messstrecke beträgt 0,5 mm/s und es werden 10 000 Datenpunkte aufgezeichnet.

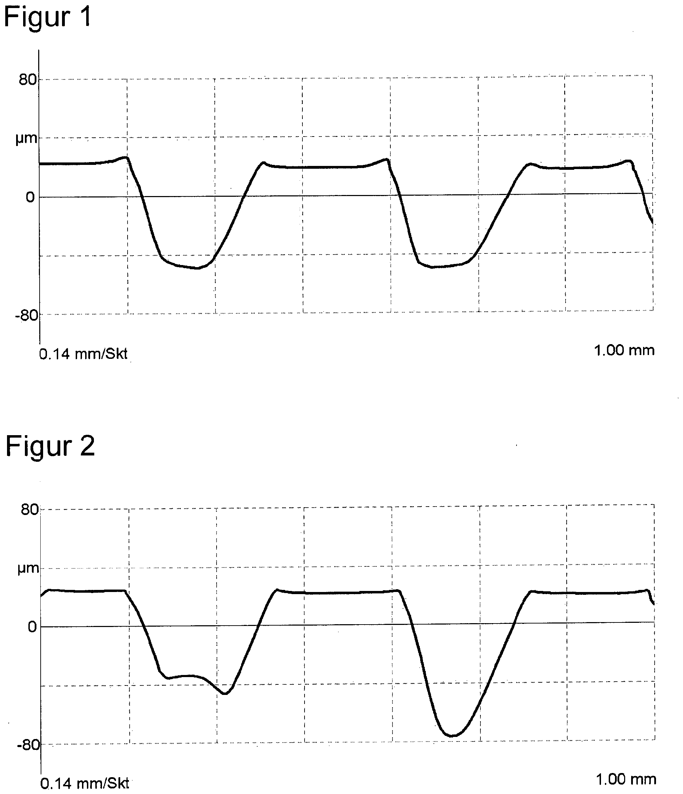

Figur 1 zeigt ein typisches Perthometer-Messergebnis für ein Klischee mit ausgeprägten hochstehenden Rändern, d.h. ausgeprägtem Cupping. Es handelt sich hier um ein nyloflex ACE 114 D-Klischee, das mittels UV-LED-Belichtung in einem Durchgang mit einer langsamen Fahrgeschwindigkeit von 65 mm/min belichtet wurde.

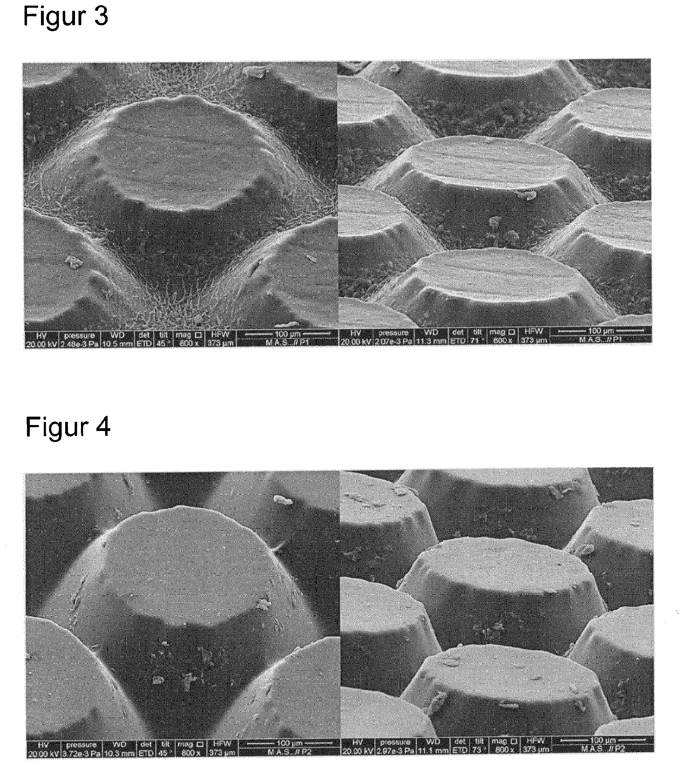

Zum Vergleich zeigt Figur 2 das entsprechende Messergebnis für ein nyloflex ACE 114 D-Klischee, das mittels UV-LED in 60 Durchgängen mit einer Fahrgeschwindigkeit von 4000 mm/min belichtet wurde. Hier sind die Ränder der Rasterpunkte kaum sichtbar. Das Cupping ist nur minimal ausgeprägt.
Die Perthometer-Ergebnisse wurden mittels elektronenmikroskopischer Aufnahmen überprüft. Figur 3 zeigt eine elektronenmikroskopische Aufnahmen des Klischees, das in einem Durchgang UV-LED belichtet wurde. Figur 4 zeigt die entsprechenden Aufnahmen an dem in 60 schnellen Durchgängen mit UV-LED belichteten Klischee. Die elektronenmikroskopischen Aufnahmen bestätigen eindrucksvoll die Ergebnisse der Perthometermessungen.

Zur quantitativen Bestimmung des Cuppings bzw. der Höhe der Rasterpunktränder wird die Perthometermessung wie folgt ausgewertet. Die Rasterpunkte haben einen Solldurchmesser von 300 µm. Um Messartefakte durch Überschwingen der Messnadel auszuschließen, wird jeweils nur der rechte (nachlaufende) Rand des Rasterpunktes vermessen. Die Höhe des Randes ergibt sich als Differenz zwischen dem höchsten Wert (direkt am Rand gemessen) und dem Messwert, der jeweils im Abstand von 30 µm vom Rand des Rasterpunktes gemessen wurde. Typische Cupping-Werte an Flexodruckklischees liegen zwischen 0 und 10 µm.

### Verarbeitung der fotopolymerisierbaren Flexodruckelemente zum Klischee

Die Energie, die pro Teilbelichtung (Belichtungszyklus) in die Druckplatte eingetragen wird, variiert von 0,1 bis 5 J/cm². Die entsprechenden Vorlaufgeschwindigkeiten werden von 50 mm/min bis 5000 mm/min variiert. Bei Verwendung eines kommerziell verfügbaren UV-LED-Gerätes (nyloflex NExT FV Belichter von Flint Group) im Großformat (1320 x 2032 mm) ergeben sich mit den angegebenen Vorlaufgeschwindigkeiten Taktzeiten von einigen Sekunden bis zu wenigen Minuten.

Als Druckplatte wurde die speziell für die Belichtung mit UV-LED-Licht entwickelte Flexodruckplatte nyloflex NEF 114 D von Flint Group verwendet.

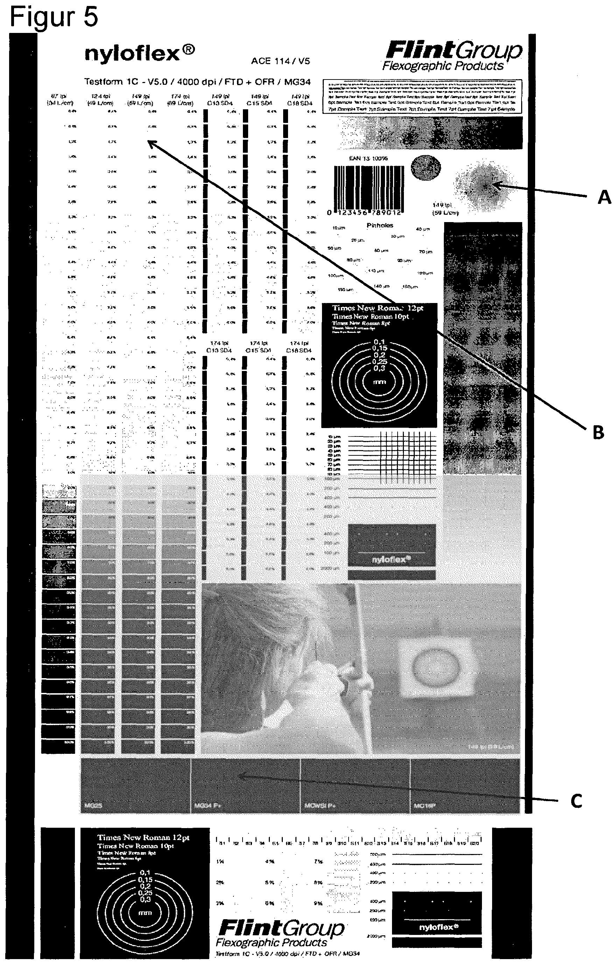

Die Verarbeitung der Flexodruckelemente umfasste die folgenden Schritte:
- Abziehen der Deckfolie
- Bebilderung mittels IR Laser (CDI Spark 4835 von Esko Graphics, hochauflösende Optik Pixel+, 4000 dpi Maskenauflösung)
- Rückseitenbelichtung auf nyloflex FIII Röhrenbelichter (16 Sek)
- UV-LED-Belichtung gemäß Tabelle 1
- Auswaschen im nyloflex FIII Wascher in nylosolv A (255mm/min)
- Trocknen (2h bei 60°C)
- Lichtnachbehandlung (10 Minuten mit UVA-Licht, 1 Minute mit UVC-Licht).
Nach dem Abziehen der Deckfolie wurden die Flexodruckplatten auf die Trommel des IR-Lasers montiert. Anschließend wurde das Testmotiv (wiedergegeben in Figur 5) mit einer Laserenergie von 3,0J/cm² in die Maskenschicht eingeschrieben. Danach wurden die Platten rückseitig vorbelichtet und anschließend mittels UV-LED Bestrahlung hauptbelichtet.

Die UV-LED-Belichtungen wurden auf dem großformatigen Belichter nyloflex NExT FV von Flint Group durchgeführt. Dieser ist für Plattenformate bis zu 1320 mm x 2032 mm ausgelegt. Jede Druckplatte wurde so belichtet, als ob eine großformatige Platte zu belichten wäre, d.h. es wurde die gesamte Länge des Belichters mit der UV-LED-Leiste abgefahren.

Die UV-LED-Leiste des nyloflex NExT FV-Belichters ist 9 mm breit. Das UV-Licht wird unter einem Winkel von 30° abgestrahlt. Der Abstand der LED-Leiste zur Platte betrug 10 mm, so dass sich eine Bestrahlungsbreite von 20,5 mm ergab. Die Leistung des Belichters wurde auf 80% der maximalen Leistung, entsprechend 650 mW/cm², eingestellt.

Es wurden Belichtungen mit den nachfolgenden Einstellungen durchgeführt:

**Tabelle 1**

| Versuchsnummer | Belichtungseinstellung | Energieeintrag / Zyklus | Gesamtdauer (min) |
|---|---|---|---|
| VV1 | 1 x 80 mm/min | 1 x 10 J/cm² | 25,8 |
| V1 | 3 x 250 mm/min | 3 x 3,2 J/cm² | 25,6 |
| V2 | 1 x 200 mm/min | 1 x4, 0 J/cm² | 38,0 |
| | + 30 x 4000 mm/min | + 30 x 0,2 J/cm² | |
| V3 | 30 x 4000 mm/min | 30 x 0,2 J/cm² | 38,0 |
| | +1 x 200 mm/min | + 1 x 4,0 J/cm² | |
| V4 | 50 x 4000 mm/min | 50 x 0,2 J/cm² | 45,7 |
| V5 | 20 x 4000 mm/min | 20 x 0,2 J/cm² | 33,7 |
| | + 2 x 1000 mm/min | + 2 x 0,8 J/cm² | |
| | + 1 x 200 mm/min | + 1 x 4,0 J/cm² | |
| V6 | Wie V5 nur im Vor- und Rücklauf belichtet | Wie V5 | 24,8 |

Die Belichtungseinstellungen wurden jeweils so gewählt, dass der gesamte Energieeintrag jeweils etwa 10 J/cm² betrug. Durch die Großformatfahrweise sind die Belichtungszeiten relativ lang und liegen zwischen 25 und 45 Minuten. Wenn nicht anders vermerkt, wurde die LED-Leiste beim Zurückfahren in die Ausgangsposition abgeschaltet. Hierdurch resultiert insbesondere bei dem Versuch V4 eine sehr lange Belichtungszeit.

In V1 wurde die Belichtung auf 3 identische Belichtungszyklen aufgeteilt.
In V2 und V3 wurden jeweils ein langsamer Durchgang mit 30 schnellen Durchgängen kombiniert. In V4 wurden nur schnelle Durchläufe realisiert und in V5 wurde die Belichtungsgeschwindigkeit von einer hohen Geschwindigkeit über eine mittlere Geschwindigkeit auf eine niedrige Geschwindigkeit verringert. In V6 waren die Belichtungsgeschwindigkeiten wie in V5, nur wurde die LED-Leiste ohne Abschaltung hin- und her gefahren, so dass sich eine signifikant kürzere Gesamtbelichtungszeit ergab.

### Klischeeauswertung

Die hergestellten Klischees wurden umfassend ausgewertet.

**Tabelle 2**

| Versuchsnummer | Härte (Micro ShoreA) | Erstes Rasterfeld (124 Ipi) | Tiefe des 200 µm Negativpunktes (µm) | Cupping (µm) |
|---|---|---|---|---|
| VV1 | 61 | 2,0 | 60 | 5,7 |
| V1 | 60 | 1,6 | 70 | 2,8 |
| V2 | 59 | 2,0 | 70 | 3,2 |
| V3 | 60 | 2,4 | 130 | 2,3 |
| V4 | 59 | 3,2 | 130 | 2,3 |
| V5 | 60 | 2,0 | 135 | 2,3 |
| V6 | 59 | 2,0 | 130 | 2,3 |

Die Härte aller Klischees lag mit 60 +/- 1 im Zielbereich.

Alle Klischees wiesen Rasterpunkte mit flachen, scharf begrenzten Oberflächen (sogenannte Flat-Top-Dots) auf. Das erste, gut versockelte Rasterfeld auf den Klischees variierte überraschenderweise nicht besonders stark und lag bei etwa 2%. Nur die Belichtungseinstellung von Versuch V4 fiel mit einem Wert von 3,2% Tonwert etwas ab. Zum Vergleich: eine mit UVA-Röhren belichtete Flexodruckplatte kann bei einer Linienweite von 124 lpi üblicherweise nur einen Tonwert zwischen 6 und 8% auf dem Klischee halten.

Bemerkenswert war der Einfluss der Belichtungseinstellungen auf das Cupping und die Tiefe des 200 µm - Negativpunktes. Die Versuchseinstellungen V1 und V2 lieferten, wie der Vergleichsversuch, nur geringe Tiefenwerte. Diese Belichtungseinstellungen zeichneten sich durch ein langsames Verfahren oder durch ein langsames Verfahren als erstem Belichtungsdurchgang aus. Versuch V3, bei dem erst am Ende der Belichtung ein langsamer Durchgang erfolgt, zeigt wie die übrigen erfindungsgemäßen Versuche wieder sehr gute (hohe) Zwischentiefen.

Das Cupping der Rasterpunkte des druckenden Reliefs zeigt eine ähnliche Abhängigkeit. Die drei Versuchseinstellungen mit langsamem Verfahren oder langsamem Verfahren der UV-LED-Leiste zu Beginn der Belichtung zeigen signifikant höhere Ränder als die übrigen Versuchseinstellungen.

Diese Ergebnisse können so interpretiert werden, dass zu Beginn der Belichtung noch eine hohe Konzentration von Vernetzer in der Druckplatte vorhanden ist. Appliziert man einen hohen Energieeintrag zu Beginn der Belichtung, entsprechend einem langsamen Verfahren der UV-LED-Leiste, dann entsteht ein signifikanter Monomerfluss, der zum Einen die Ausbildung hochstehender Ränder an den Grenzen zwischen belichteten und unbelichteten Bereichen verursacht und zum Anderen - wiederum an der Grenze zwischen belichteten und unbelichteten Bereichen der Druckplatte - die Verringerung der Tiefe der Negativpunkte (Zwischentiefe) durch Polymerisation zur Folge hat. Für jedes Volumenelement der fotopolymerisierbaren Schicht wirken sich die konkurrierenden Reaktionen Radikalbildung, Polymerisation, Abbruch durch Sauerstoff und Diffusion des Vernetzers anders aus. An der Oberfläche der Flexodruckplatte ist die Nachdiffusion des Sauerstoffs noch wesentlich und verhindert, dass die Polymerisation über die Grenze zwischen belichteten und unbelichteten Bereichen in den unbelichteten Bereich hineinwächst. Hier bestimmt die Monomerdiffusion das Entstehen der typischen hochstehenden Ränder. Etwa 100 µm von der Oberfläche entfernt (im Bereich der Tiefe eines feinen Negativ-Punktes) spielt der Sauerstoff keine Rolle mehr. Der Sauerstoff diffundiert nicht tief genug in die fotopolymerisierbare Schicht hinein, um die Polymerisation in den Nichtbildbereichen zu inhibieren. Bei hohen Energiedosen pro Belichtungsschritt und einer entsprechend hohen Konzentration an freien Radikalen diffundieren diese verstärkt in die Nichtbildbereiche hinein, wodurch die Zwischentiefen zwischen den Bildpunkten durch Polymerisation verringert werden.

Wird erst zum Ende der Belichtung ein Zyklus mit hohem Energieeintrag (durch langsames Verfahren der UV-LED-Leiste) durchgeführt, dann ist ein Teil des Vernetzers (Monomer) schon verbraucht, und es kommt trotz hohem Energieeintrag nicht mehr zu einem signifikanten Monomerfluss. Die Zwischentiefen zwischen den Bildpunkten bleiben offen und die Ränder der Rasterpunkte sind nicht mehr so stark ausgeprägt.

### Druckversuche

Die Klischees wurden anschließend unter identischen Bedingungen auf einer Flexodruckmaschine angedruckt und die erhaltenen Drucke ausgewertet.

### Druckparameter

Druckmaschine: W&H Zentralzylindermaschine
Druckfarbe: Alkohol basierte Flexodruckfarbe Flexistar Cyan
Klebeband: Lohmann 5.3
Druckgeschwindigkeit: 100 m/min
Druckbeistellung: optimal (+ 70 µm über Kissprint-Einstellung; Kissprint nennt man die Beistellung, bei der etwa die Hälfte aller Bildelemente ausdrucken. Hier berührt der Druckzylinder mit dem Substrat gerade die Klischeeoberfläche, ohne dass wesentlicher Druck ausgeübt wird).

**Tabelle 3**

| Versuchs-Nummer | Tonwert erstes Rasterfeld (124 lpi) | Log. Farbdichte (MG34) | Punktbrücken (Dot-Bridging) | Drucckennlinie | Beurteilung Druckqualität |
|---|---|---|---|---|---|
| VV1 | 17,6 | 1.67 | stark | unstetig | schlecht |
| V1 | 15,4 | 1.69 | gering | stetig | gut |
| V2 | 20,1 | 1.67 | gering | stetig | gut |
| V3 | 18,6 | 1.63 | keine | stetig | sehr gut |
| V4 | 20,4 | 1.59 | keine | stetig | gut |
| V5 | 17,0 | 1.65 | keine | stetig | sehr gut |
| V6 | 18,3 | 1.63 | keine | stetig | sehr gut |

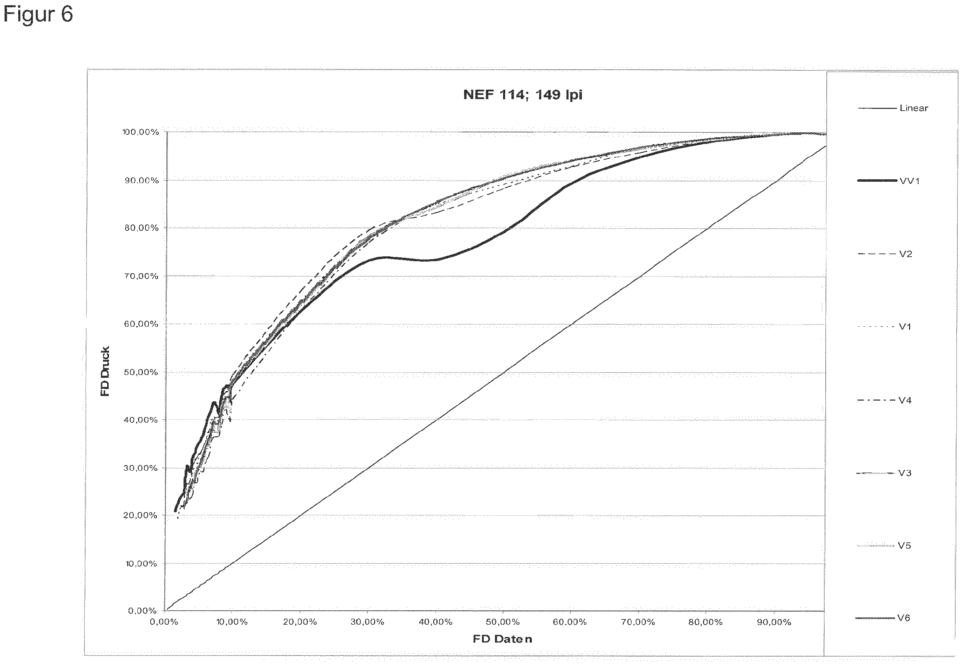

Als empfindliches Testelement für das Auftreten von Punktbrücken (Dot-Bridging) wurde ein kreisförmiger Rasterverlauf (Motiv A in Abbildung 5) verdruckt. Ferner wurden jeweils der Tonwert des ersten druckenden Rasterfeldes (Motiv B) und die entsprechende Tonwertkennlinie (siehe Abbildung 6) ermittelt. Die Farbdichte der oberflächenstrukturierten Vollfläche (ausgewählter Oberflächenraster MG 34, Motiv C) wurde densitometrisch ermittelt. Ferner wurde das gesamte Druckbild im Hinblick auf Kontrast, Detailschärfe und Farbliegen von mehreren Testpersonen beurteilt und in drei Kategorien (sehr gut, gut, schlecht) eingeteilt.

Alle Klischees druckten den ersten Rastertonwert mit einer Flächendeckung zwischen 15 und 20%, was für FTD-Klischees bei einer Rasterweite von 124 lpi üblich ist. Ebenso zeigen alle Drucke eine hohe Farbdichte im Bereich der mittels Oberflächenraster strukturierten Vollfläche. Die unstrukturierte Oberfläche bringt dagegen im Mittel nur eine Farbdichte von 1,5 +/- 0,05.

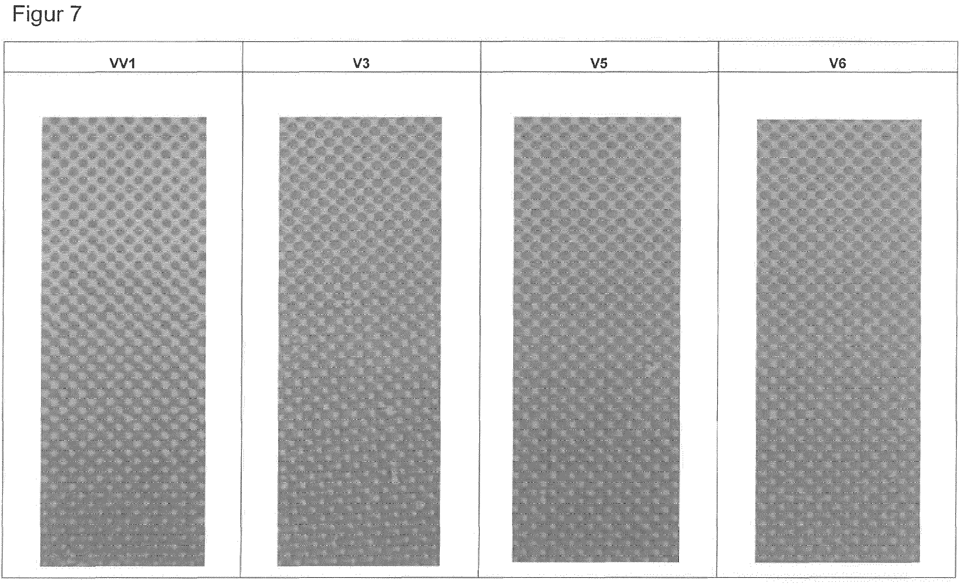

Das Problem der Farbbrückenbildung bei mittleren Tonwerten von 30 bis 60% wird an Hand der Druckkennlinie und im Druck des kreisförmigen Rasterverlaufes (Motiv A) sichtbar. Figur 6 zeigt die zu den Versuchen VV1 und V1 bis V6 gehörigen Druckkennlinien. In einer Druckkennlinie werden Rasterfelder mit unterschiedlicher Flächendeckung gedruckt und ausgewertet. Die Farbflächendeckung im Druck (densitometrisch gemessen im Vergleich zur optischen Dichte der Vollfläche - in Prozent) wird der theoretischen Flächendeckung des Datensatzes gegenübergestellt. Durch das Quetschen der Druckfarbe ist die Flächendeckung im Druck höher als die theoretisch errechnete druckende Oberfläche. Druckkennlinien im Flexodruck zeigen daher eine typische konvexe Wölbung über der Diagonalen im Diagramm. Zur Darstellung gerasterter Bilder ist es notwendig, dass diese Wölbung reproduzierbar und stetig ist. Unstetigkeiten in der Druckkennlinie zeigen Probleme an, die die Rasterreproduktion unmöglich macht. Abbildung 7 zeigt Fotografien vergrößerter Aufnahmen der Rasterpunkte des Kreisrasters für die Druckversuche VV1, V3, V5 und V6.

Im Vergleichsversuch VV1 kann man die Farbbrückenbildung bereits bei niedrigen Tonwerten in der Mikroskopaufnahme erkennen, obwohl die Rasterpunkte ausreichend Abstand voneinander haben und keinen Kontakt zueinander haben sollten. Die anderen Belichtungseinstellungen zeigen keine Farbbrücken. Auch bei größeren Rasterpunkten, die sich fast berühren, druckte hier jeder einzelne Punkt noch sauber getrennt aus.

Auch beim Vergleich der Druckkennlinien schneidet der Vergleichsversuch VV1 schlecht ab. Im Bereich der mittleren Tonwerte fällt die Druckkennlinie ab und zeigt im Bereich von 30% bis 50% ein fast horizontales Verhalten. Diese Delle in der Druckkennlinie ist bei dem Vergleichversuch VV1 extrem stark ausgeprägt. Alle anderen Belichtungseinstellungen zeigen eine kontinuierlich ansteigende, stetige Druckkennlinie.

Die Druckergebnisse korrelieren mit den Auswertungen der Klischees. Klischees mit ausgeprägtem Cupping und unzureichenden Zwischentiefen zwischen den Bildpunkten tendieren folglich zur Ausbildung von Farbbrücken im hochqualitativen Rasterdruck. Die dünnflüssige Druckfarbe wird beim Kontakt mit dem Substrat über die Ränder des Rasterpunktes hinaus gequetscht. Die Druckfarbe läuft in die flachen Zwischentiefen zwischen den Rasterpunkten und trocknet dort an. Beim nächsten Druckdurchgang wiederholt sich der Vorgang, bis schließlich eine druckende Farbbrücke entsteht.

Die Versuche belegen eindrucksvoll, dass die Belichtungseinstellungen, mit denen das Entstehen von hochstehenden Rändern verhindert werden kann und ausreichend hohe Zwischentiefen zwischen den Bildpunkten erzielt werden, auch die optimalen Druckergebnisse ermöglichen. Insbesondere die Belichtungseinstellungen V3, V5 und V6 in denen zunächst mehrere Belichtungen mit niedrigem Energieeintrag (schnelles Verfahren der UV-LED-Leiste) vorgenommen werden und am Ende der Belichtung dann eine oder mehrere Belichtungen mit höherem Energieeintrag (langsameres Verfahren der UV-LED-Leiste) realisiert werden, schneiden in Punkto Druckqualität am besten ab. V6 realisiert darüber hinaus noch eine optimale Druckqualität mit einer kurzen Belichtungszeit.

## Patentansprüche

1. Verfahren zur Herstellung von Flexodruckformen, bei dem man als Ausgangsmaterial ein fotopolymerisierbares Flexodruckelement einsetzt, welches übereinander angeordnet mindestens umfasst:
• einen dimensionsstabilen Träger, und
• mindestens eine fotopolymerisierbare reliefbildende Schicht, mindestens umfassend ein elastomeres Bindemittel, eine ethylenisch ungesättigte Verbindung und einen Fotoinitiator,
• eine digital bebilderbare Schicht,
und das Verfahren mindestens die folgenden Schritte umfasst:
(a) Erzeugung einer Maske durch Bebilderung der digital bebilderbaren Schicht,
(b) Belichtung der fotopolymerisierbaren reliefbildenden Schicht durch die Maske hindurch mit aktinischem Licht und Fotopolymerisation der Bildbereiche der Schicht, und
(c) Entwicklung der fotopolymerisierten Schicht durch Auswaschen der nicht fotopolymerisierten Bereiche der reliefbildenden Schicht mit einem organischen Lösungsmittel oder durch thermische Entwicklung, **dadurch gekennzeichnet, dass**
der Schritt (b) zwei oder mehr Belichtungszyklen (b-1) bis (b-n) mit aktinischem Licht mit einer Intensität von 100 bis 5 000 mW/cm² aus einer Mehrzahl von UV-LEDs umfasst, wobei die pro Belichtungszyklus in die fotopolymerisierbare reliefbildende Schicht eingetragene Energie 0,1 bis 5 J/cm² beträgt.

2. Verfahren nach Anspruch 1, **dadurch gekennzeichnet, dass** die in Schritt (b) in die fotopolymerisierbare reliefbildende Schicht insgesamt eingetragene Energie 5 bis 25 J/cm² beträgt.

3. Verfahren nach Anspruch 1, **dadurch gekennzeichnet, dass** die pro Belichtungszyklus eingetragene Energie über den Belichtungsschritt (b) zunimmt.

4. Verfahren nach einem der Ansprüche 1 bis 3, **dadurch gekennzeichnet, dass** der Belichtungsschritt (b) durch Relativbewegung der Mehrzahl von UV-LEDs parallel zur Oberfläche des Flexodruckelements durchgeführt wird.

5. Verfahren nach Anspruch 4, **dadurch gekennzeichnet, dass** die Mehrzahl der UV-LEDs auf mindestens einer UV-LED-Leiste nebeneinander angeordnet ist, die entlang der Oberfläche des Flexodruckelements bewegt wird.

6. Verfahren nach Anspruch 4 oder 5, **dadurch gekennzeichnet, dass** die Mehrzahl der UV-LEDs auf mindestens zwei UV-LED-Leisten nebeneinander angeordnet ist, von denen mindestens eine beweglich und mindestens eine feststehend ist.

7. Verfahren nach einem der Ansprüche 4 bis 6, **dadurch gekennzeichnet, dass** die LED-Leiste oder die LED-Leisten mit einer Geschwindigkeit von 50 bis 5 000 mm/min relativ zur Oberfläche des Flexodruckelements bewegt werden.

8. Verfahren nach einem der Ansprüche 1 bis 7, **dadurch gekennzeichnet, dass** die in Schritt (b) eingesetzten UV-LEDs ein Emissionsmaximum im Wellenlängenbereich von 350-405 nm aufweisen.

9. Verfahren nach Anspruch 8, **dadurch gekennzeichnet, dass** die in Schritt (b) eingesetzten UV-LEDs ein Emissionsmaximum bei 350 nm, 365 nm, 375 nm, 385 nm, 395 nm oder 405 nm aufweisen.

10. Verfahren nach einem der Ansprüche 1 bis 9, **dadurch gekennzeichnet, dass** die digital bebilderbare Schicht eine laserablatierbare Schicht ist.

11. Verfahren nach einem der Ansprüche 1 bis 10, **dadurch gekennzeichnet, dass** der Abstand der UV-LEDs zur Oberfläche des Flexodruckelements 5 bis 30 mm beträgt.

## Claims

1. Method for producing flexographic printing formes, in which the starting material used is a photo-polymerisable flexographic printing element, which comprises at least the following arranged above one another:
• a dimensionally stable carrier, and
• at least one photo-polymerisable relief-forming layer, at least comprising an elastomer binder, an ethylenically unsaturated compound and a photo initiator,
• a digitally imageable layer,
and the method comprises at least the following steps:
(a) producing a mask by imaging the digitally imageable layer,
(b) exposing the photo-polymerisable relief-forming layer through the mask with actinic light and photo-polymerisation of the image regions of the layer, and
(c) developing the photo-polymerisable layer by washing out the non-photo-polymerised regions of the relief-forming layer with an organic solvent or by thermal development, **characterized in that**
step (b) comprises two or more exposure cycles (b-1) to (b-n) with actinic light with an intensity of 100 to 5000 mW/cm² from a plurality of UV LEDs, wherein the energy input into the photo-polymerisable relief-forming layer per exposure cycle is 0.1 to 5 J/cm².

2. Method according to Claim 1, **characterized in that** the total energy input into the photo-polymerisable relief-forming layer is step (b) is 5 to 25 J/cm².

3. Method according to Claim 1, **characterized in that** the energy input per exposure cycle increases over the exposure step (b).

4. Method according to one of Claims 1 to 3, **characterized in that** the exposure step (b) is carried out by relative movement of the plurality of UV LEDs parallel to the surface of the flexographic printing element.

5. Method according to Claim 4, **characterized in that** the plurality of UV LEDs is arranged beside one another on at least one UV LED strip, which is moved along the surface of the flexographic printing element.

6. Method according to Claim 4 or 5, **characterized in that** the plurality of UV LEDs is arranged beside one another on at least two UV LED strips, of which at least one is movable and at least one is stationary.

7. Method according to one of claims 4 to 6, **characterized in that** the LED strip or the LED strips are moved at a speed of 50 to 5000 mm/min relative to the surface of the flexographic printing element.

8. Method according to one of Claims 1 to 7, **characterized in that** the UV LEDs used in step (b) have an emission maximum in the wavelength range from 350-405 nm.

9. Method according to Claim 8, **characterized in that** the UV LEDs used in step (b) have an emission maximum of 350 nm, 365 nm, 375 nm, 385 nm, 395 nm or 405 nm.

10. Method according to one of Claims 1 to 9, **characterized in that** the digitally imageable layer is a laser-ablatable layer.

11. Method according to one of Claims 1 to 10, **characterized in that** the distance of the UV LEDs from the surface of the flexographic printing element is 5 to 30 mm.

## Revendications

1. Procédé de fabrication de plaques d'impression flexographiques, procédé dans lequel le matériau de départ utilisé est un élément d'impression flexographique photo-polymérisable qui comprend au moins de manière superposée :
• un support indéformable, et
• au moins une couche photo-polymérisable, formant un relief, comprenant au moins un liant élastomère, un composé à insaturation éthylénique et un photoinitiateur,
• une couche pouvant former une image numérique,
et le procédé comprenant au moins les étapes suivantes :
(a) générer un masque par formation d'une image de la couche pouvant former une image numérique,
(b) exposer la couche photo-polymérisable formant un relief à une lumière actinique par le biais du masque et photo-polymériser les zones d'image de la couche, et
(c) développer la couche photo-polymérisée par lavage des zones non photo-polymérisées de la couche formant un relief avec un solvant organique ou par développement thermique, **caractérisé en ce que**
l'étape (b) comprend au moins deux cycles d'exposition (b-1) à (bn) avec une lumière actinique d'intensité allant de 100 à 5000 mW/cm² d'une pluralité de LED UV, l'énergie apportée, par cycle d'exposition, à la couche photo-polymérisable formant un relief étant de 0,1 à 5 J/cm².

2. Procédé selon la revendication 1, **caractérisé en ce que** l'énergie totale apportée à l'étape (b) dans la couche photo-polymérisable formant un relief est de 5 à 25 J/cm².

3. Procédé selon la revendication 1, **caractérisé en ce que** l'énergie apportée par cycle d'exposition augmente au cours de l'étape d'exposition (b).

4. Procédé selon l'une des revendications 1 à 3, **caractérisé en ce que** l'étape d'exposition (b) est réalisée par déplacement relatif de la pluralité de LED UV parallèlement à la surface de l'élément d'impression flexographique.

5. Procédé selon la revendication 4, **caractérisé en ce que** la pluralité de LED UV sont disposées côte à côte sur au moins une bande de LED UV qui est déplacée le long de la surface de l'élément d'impression flexographique.

6. Procédé selon la revendication 4 ou 5, **caractérisé en ce que** la pluralité de LED UV sont disposées côte à côte sur au moins deux bandes de LED UV dont l'une au moins est mobile et l'une au moins fixe.

7. Procédé selon l'une des revendications 4 à 6, **caractérisé en ce que** l'au moins une bande de LED est déplacée à une vitesse de 50 à 5000 mm/min par rapport à la surface de l'élément d'impression flexographique.

8. Procédé selon l'une des revendications 1 à 7, **caractérisé en ce que** les LED UV utilisées à l'étape (b) présentent un maximum d'émission dans la gamme de longueurs d'onde allant de 350 à 405 nm.

9. Procédé selon la revendication 8, **caractérisé en ce que** les LED UV utilisées à l'étape (b) présentent un maximum d'émission à 350 nm, 365 nm, 375 nm, 385 nm, 395 nm ou 405 nm.

10. Procédé selon l'une des revendications 1 à 9, **caractérisé en ce que** la couche pouvant former une image numérique est une couche éliminable par laser.

11. Procédé selon l'une des revendications 1 à 10, **caractérisé en ce que** la distance des LED UV à la surface de l'élément d'impression flexographique est de 5 à 30 mm.
